# EUROPEAN PATENT APPLICATION

(11) **EP 2 392 694 A1**
(43) Date of publication of application: **07.12.2011**
(21) Application number: 10164728.7
(22) Date of filing: 02.06.2010
(51) Int. Cl.: C23F 1/18, H05K 3/06

(54) **Method for etching of copper and copper alloys**

(71) Applicant: ATOTECH Deutschland GmbH, 10553 Berlin (DE)
(72) Inventor: Muranushi, Yoshihisa, 226-0006, Yokohama (JP); Matsumoto, Hideki, Yokohama, 226-0006 (JP); Inuzuka, Masahiro, 226-0006, Yokohama (JP)
(74) Representative: Wonnemann, Jörg

(57) **Abstract**

The present invention is concerned with improved means for etching circuit structures on printed circuit board or wafer substrates of copper or copper alloys in a manner effectively removing unwanted copper from such circuit structures leaving behind a smooth copper surface applying an etching solution containing an Fe(ll) / Fe(lll) redox system and sulfur containing organic additives. It is an advantage of the present invention that the solution can also applied for plating of copper prior to etching.

## Description

### Field of the Invention

The present invention relates to a method for etching surfaces of copper or copper alloys, particularly of circuit structures made from copper or copper alloys. More particularly the present invention is concerned with improved means for etching circuit structures on printed circuit boards or wafer substrates of copper or copper alloys in a manner effectively removing unwanted copper from such circuit structures leaving behind a smooth copper surface.

### Relevant state of the art

Etching compositions for etching of copper on circuit structures like printed circuit boards and wafer substrates are known in the art. Usually, such etching compositions comprise an etchant like ferric or cupric chloride. UK patent 1,154,015 discloses an etching composition comprising ferric chloride, ethylene thiourea and film forming compounds like pyrogallol and tannic acid.

DE 41 18 746 A1 is concerned with a method for etching of copper using ferric chloride and organic acids like citric acid as complexing agent.

Many modifications of such etching solutions are known, all of which result in strong etching leaving rough copper surfaces.

### Brief description of the figures

Figure 1A shows etching patterns of copper in blind micro vias obtained by a method according to the present invention as compared to the prior art.
Figure 1B shows etching patterns of copper in bumps or lines obtained by a method according to the present invention as compared to the prior art.
Figures 2A and 2B show etching patterns and dimensions for small and large vias obtained by a method according to the present invention as compared to the prior art.

### Objects of the invention

Therefore, it is the object underlying the present invention to provide a method for etching circuit structures on printed circuit board or wafer substrates of copper or copper alloys in a manner effectively removing unwanted copper from such circuit structures leaving behind a smooth copper surface.

Such etching steps are typically performed after plating of copper on the substrate to create the desired circuitry.

### Detailed description of the invention

Aqueous acidic baths for electrolytic deposition of copper are used for manufacturing of printed circuit boards and chip carriers where fine structures like trenches, through holes, blind micro vias and pillar bumps need to be filled with copper. Critical performance parameters like ski-slope, round-shape and dimple formation have to be minimized or even avoided. The method according to the present invention can be applied to substrates used in Wafer Level Packaging, Chip Level Packaging and Flip chip techniques which are known in the art.

Furthermore, acid aqueous copper electrolytes are applied for metallization processes on wafer substrates within the so called backend in the production of integrated circuits. Such processes comprise electrolytic copper depositions for the formation of redistribution layers (RDL) and for pillar bumping. RDL are well known in the art and are for example described in US 2005/0104187 A1. Generally, an RDL is formed over an interconnect and adjacent portion of the insulating layer of one substrate to provide a path or link to the misaligned opposing interconnection of the second substrate.

Thereby a photoresist mask is used to define the microstructures to be filled with electrolytic copper. Typical dimensions for RDL patterns are 20 to 300 µm for circular land pad and 5 to 30 µm for Line and Space applications; copper thicknesses are usually in the range of 3 to 8 µm. Deposit thickness homogeneity within the microstructure (profile uniformity), within the chip/die area (within die uniformity = WID) and within the wafer (within wafer uniformity = WIW) is a critical criteria. In-die non-uniformity values of less than 5-10 % and profile non-uniformity values of less than 3-5 % are required for said applications. Pillar bumping applications require copper layer thicknesses of about 1 to 90 µm. The pillar diameters are typically in the range of 20 to 300 µm. In-die non-uniformity and within-bump non-uniformity values of less than 10 % are typical specifications.

The final etching step to create the desired circuitry must not result in excessive roughening and non-uniform etching of the fine structures in order not to negatively affect the performance of the circuitry. Therefore, standard etching agents based on cupric chloride or ferric chloride as known in the art and described above are to harsh. Their application to fine copper structures results in over-etching and excessive roughening of the copper surface.

It is a characteristic feature of the present invention that the electrolytic plating bath used in at least one plating step to form the copper structures can also be applied for the etching step which follows the metal plating process.

A typical plating composition which is suitable for plating copper structures is described in the following.

The aqueous acidic bath composition for electrolytic deposition of copper contains at least one source of copper ions which is preferably selected from the group comprising copper sulphate and copper alkylsulfonates. Also, the copper ions can be provided by oxidation of metallic copper to copper(II) ions. This method to form a copper ion source is described in more detail below. The copper ion concentration ranges from 15 g/l to 75 g/l.

The at least one source of acid is selected from the group comprising sulphuric acid, fluoro boric acid and methane sulfonic acid. The concentration of the acid ranges from 20 g/l to 400 g/l, more preferred from 50 g/l to 300 g/l.

The bath additionally contains at least one organic sulfur brightener additive. Organic sulfur brightener additives for copper plating are well known in the art.

For example, the at least one organic sulfur brightener additive is selected from the group consisting of 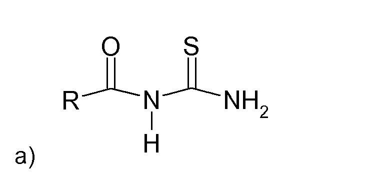 wherein R = H, C₁-C₄ alkyl 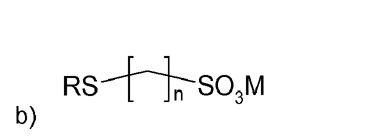 wherein R = H, C₁-C₄ alkyl, n = 1-6 and M = H, metal ion 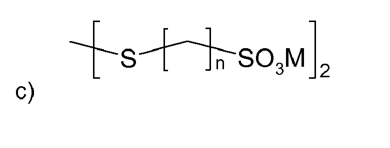 wherein n = 1-6 and M = H, metal ion 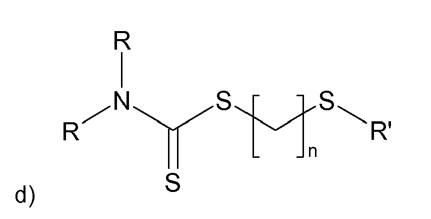 wherein n = 1-6 and R, R' =H, C₁-C₆ alkyl 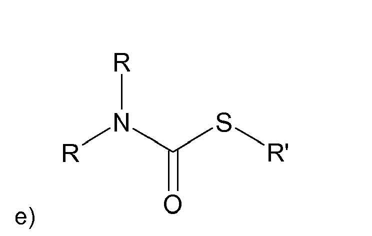 wherein R, R' = H, C₁-C₆ alkyl 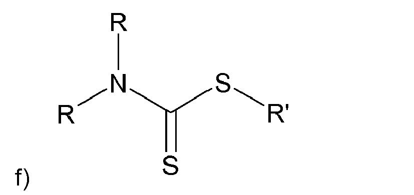 wherein R, R' = H, C₁-C₆ alkyl 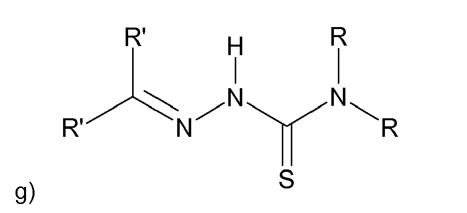 wherein R, R' = H, C₁-C₆ alkyl 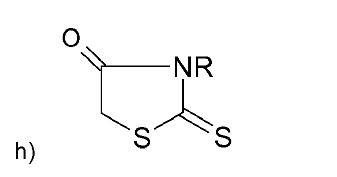 wherein R = H, C₁-C₆ alkyl
R preferably is selected from the group consisting of H, CH₃ and C₂H₅. R' preferably is selected from the group consisting of H, CH₃ and C₂H₅. The integer n preferably is 2, 3 or 4.

Preferred organic sulfur brightener additives are selected from the group consisting of 3-(benzthiazolyl-2-thio)-propylsulfonic-acid, 3-mercaptopropan-1-sulfonic-acid, ethylendithiodipropylsulfonic-acid, bis-(p-sulfophenyl)-disulfide, bis-(ω-sulfobutyl)-disulfide, bis-(ω-sulfohydroxypropyl)-disulfide, bis-(ω-sulfopropyl)-disulfide, bis-(ω-sulfopropyl)-sulfide, methyl-(ω-sulfopropyl)-disulfide, methyl-(ω-sulfopropyl)-trisulfide, O-ethyl-dithiocarbonic-acid-S-(ω-sulfopropyl)-ester, thioglycol-acid, thiophosphoric-acid-O-ethyl-bis-(ω-sulfopropyl)-ester, thiophosphoric-acid-tris-(ω-sulfopropyl)-ester and their corresponding salts.

The concentration of all organic sulfur brightener additives present in the aqueous acidic copper bath compositions ranges from about 0.01 mg/l to about 100 mg/l, more preferred from about 0.05 mg/l to about 20 mg/l.

The inventive aqueous acidic bath compositions for electrolytic deposition of copper may further contain at least one carrier-supressor additive which is usually a polyalkylenglycol compound (US 4,975,159) and is selected from the group comprising polyvinylalcohol, carboxymethylcellulose, polyethylenglycol, polypropylenglycol, stearic acid polyglycolester, oleic acid polyglycolester, stearylalcoholpolyglycolether, nonylphenolpolyglycolether, octanolpolyalkylenglycolether, octanediol-bis-(polyalkylenglycolether), poly(ethylenglycolran-propylenglycol), poly(ethylenglycol)-block-poly(propylenglycol)-block-poly(ethyleneglycol), poly(propylenglycol)-block-poly(ethylenglycol)-block-poly(propylenglycol). The concentration of said carrier-supressor additives ranges from 0.005 g/l to 20 g/l, more preferred from 0.01 g/l to 5 g/l.

The inventive aqueous acidic bath for electrolytic deposition of copper can further contain at least one source of halogenide ions, preferred chloride ions in a quantity of 20 mg/l to 200 mg/l, more preferred from 30 mg/l to 60 mg/l.

A preceding copper plating bath can be used in a first plating step to form the copper structures.

A typical plating composition which is suitable for etching also additionally contains a Fe(ll) / Fe(lll) redox system. The concentration of iron(lll) ions is 1 - 25 g/l in general and preferably 3-10 g/l. The concentration of the iron(ll) ions is a result of the redox potential of the system. Generally an iron(lll) salt is applied to the solution to generate the redox system. Suitable iron(lll) salts comprise iron(lll)sulphate. Alternatively, an iron(ll)salt may be applied as iron source, e.g. a iron(ll)sulphate, from which the redox pair also forms. Using the plating method according to the present invention to form copper structures the following two plating methods can be applied

### Method 1:

1. Plating of copper structures on a substrate using an electroplating bath of above described composition but without Fe(ll) / Fe(lll) redox system first and thereafter
2. Further plating of copper structures on said substrate using an electroplating bath of above described composition but with a Fe(ll) / Fe(lll) redox system and thereafter
3. Etching of plated copper in a bath according to step 2. without applying a current.
The plating sequence as described by method 1 can be advantageous if substrate structures like lines and vias need to be filled by copper plating in addition to plating of copper layers on the top surface of the substrate.

The steps 2 and 3 of Method 1 can be performed in the same or separate baths, preferably in the same bath.

### Method 2:

1. Plating of copper structures on a substrate using an electroplating bath of above described composition with Fe(ll) / Fe(lll) redox system first and thereafter
2. Etching of plated copper in a bath according to step 1. without applying a current.
The steps 1 and 2 of Method 2 can be performed in the same or separate baths, preferably in the same bath.

Additionally, a third, but less preferred method, comprises the following steps:

### Method 3:

1. Plating of copper structures on a substrate using an electroplating bath of above described composition but without Fe(ll) / Fe(lll) redox system first and thereafter
2. Etching of plated copper in a separate bath with a composition according to the bath according to step 1. but Fe(ll) / Fe(lll) redox system without applying a current.

During electroplating of copper the aqueous acidic plating bath is operated during electrolytic copper deposition in a preferred temperature range of 15 °C to 50 °C, more preferred from 25°C to 40 °C and a cathodic current density range of 0.05 A/dm² to 12 A/dm², preferred 0.1 A/dm² to 7 A/dm².

As anodes preferably insoluble dimensionally stable anodes are used for electroplating. By using the dimensionally stable, insoluble anodes, a constant spacing can be set between the anodes and the substrates, e.g. the wafers. The anodes are easily adaptable to the substrates with respect to their geometrical shape and, contrary to soluble anodes, they practically do not change their geometrical external dimensions. In consequence, the spacing between the anodes and the substrates, which influences the distribution of layer thickness on the surface of the substrates, remains constant.

To produce insoluble anodes, (inert) materials which are resistant to the electrolyte are used, such as stainless steel or lead for example. Anodes are preferably used which contain titanium or tantalum as the basic material, which is preferably coated with noble metals or oxides of the noble metals. Platinum, iridium or ruthenium, as well as the oxides or mixed oxides of these metals, are used, for example, as the coating. Besides platinum, iridium and ruthenium, rhodium, palladium, osmium, silver and gold, or respectively the oxides and mixed oxides thereof, may also basically be used for the coating. All anodes can be expanded metal anodes.

Since the copper ions consumed during the deposition from the deposition solution cannot be directly supplied by the anodes by dissolution, said ions can be supplemented in two different ways. Addition of copper can be as copper (ll) salts as mentioned above. Alternatively, copper (ll) ions can be supplemented by chemically dissolving corresponding copper parts or copper-containing shaped bodies. Copper ions are formed from the copper parts or shaped bodies in a redox reaction by the oxidising effect of the Fe(lll) compounds contained in the deposition solution.

To supplement the copper ions consumed by deposition a copper ion generator is used, which contains metallic parts of copper. To regenerate the deposition solution, which is weakened by a consumption of copper ions, said solution is guided past the anodes, whereby Fe(lll) compounds are formed from the Fe(ll) compounds by oxidation. The solution is subsequently conducted through the copper ion generator and thereby brought into contact with the copper parts. The Fe(lll) compounds thereby react with the copper parts to form copper ions, i.e. the copper parts dissolve. The Fe(lll) compounds are simultaneously converted into the Fe(ll) compounds. Because of the formation of the copper ions, the total concentration of the copper ions contained in the deposition solution is kept constant. The deposition solution passes from the copper ion generator back again into the electrolyte chamber which is in contact with the substrates and the anodes. The method is known in the art and for example described is US 6,793,795.

Alternatively, instead of chemically forming copper ions the copper ions can be provided by adding soluble copper(ll)salts like copper oxide to the plating bath.

After the plating process has been completed the current supply is stopped and the etching method of the copper according to the present invention can be started.

The etching is performed by applying the solution to the substrate for a period of time. The time for etching generally ranges between 10 - 60 minutes and depends on the applications and the desired etching rate. The etching is performed at a temperature similar to the plating temperature which usually ranges between 15°C and 60°C, preferably between 20° and 30°C.

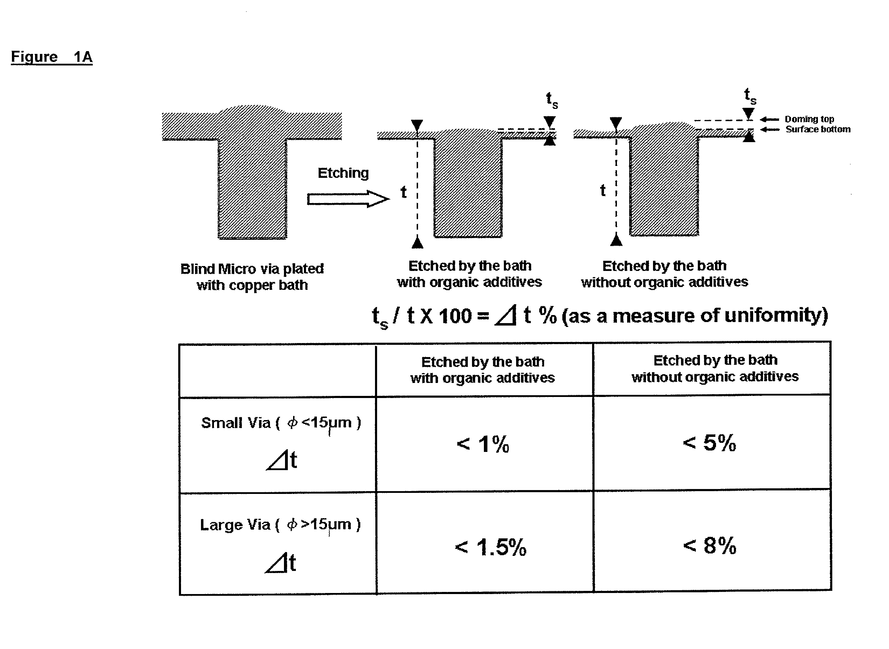

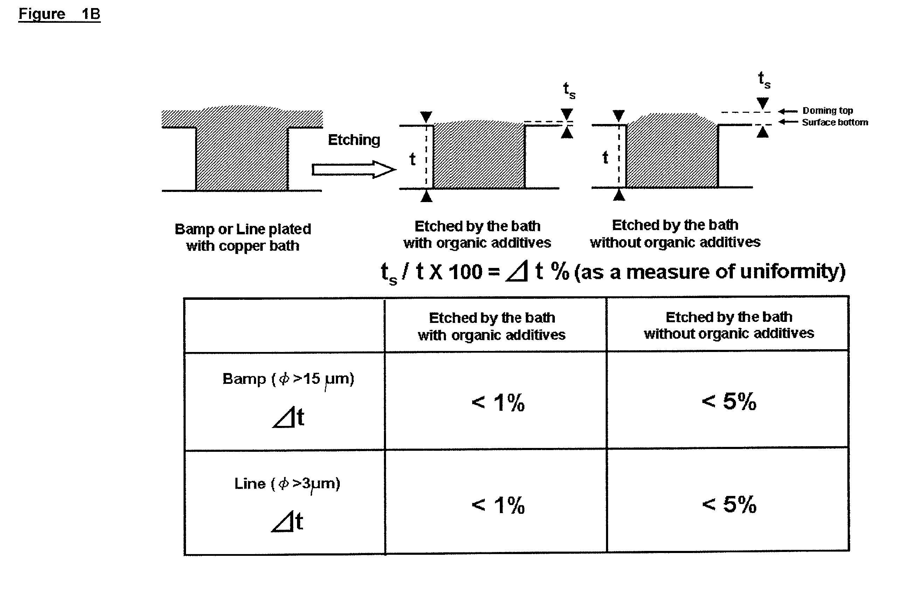

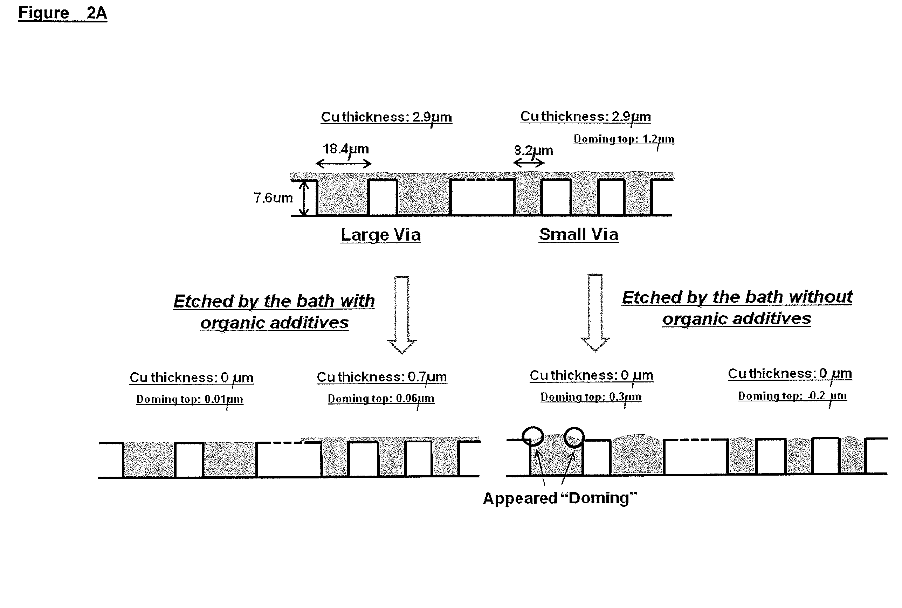

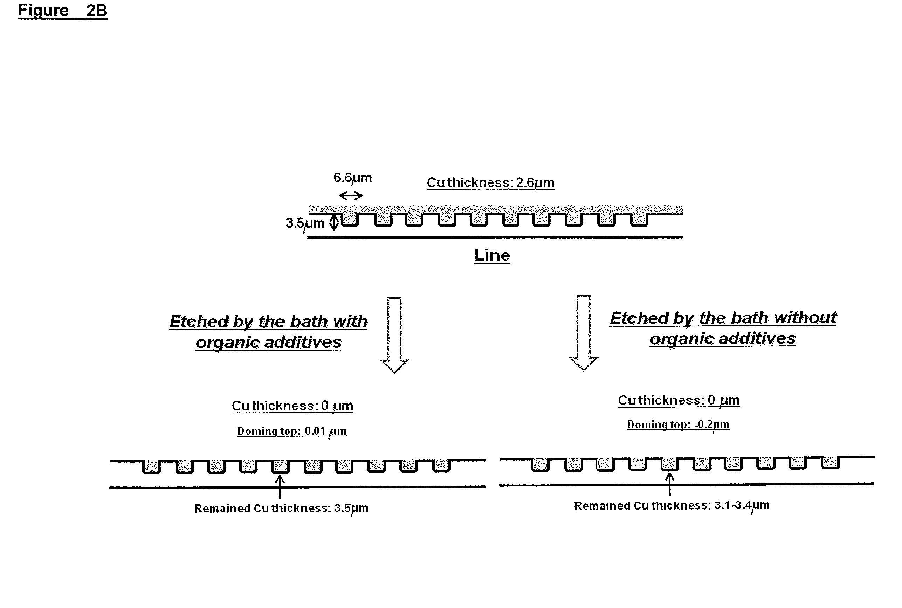

The etching of copper on the substrate surface can be to an extent as shown in Figures 1A and 1B, where a thin layer of electrodeposited copper remains on the substrate surface. Also, the etching of copper on the substrate surface can be completely as shown in Figures 2A and 2B where after etching has been performed electroplated copper only rains in the line structures but not on the surface of the subsrate.

Preferably, the etching is performed in the same bath as the plating process is performed by turning off the current. Alternatively, a second bath particularly for the etching step may be provided. The composition contained in this bath would correspond to that of the plating bath as described above. The presence of anodes would not be required in the latter case.

It is an advantage of the present invention that no additional etching baths or other planarization methods like chemical mechanical polishing are required when preparing substrates having copper bumps or redistribution layers. Furthermore, applying a solution for etching according to the present invention results is smoothly etched surfaces which can not be obtained by etching methods known from the art.

This process enables one to establish a closed recycling system wherein the etching solution can be reused as electrolytic solution after functioning as etchant for a certain period of time in one embodiment of the present invention. In another embodiment of the present invention the solution can be used as etchant for copper after having been used as electrolytic solution in a bath for copper plating for some time. In one embodiment, it is another advantage of the present invention that there is no need to replenish of metallic copper, Cu(ll)ions and the Fe(ll)/Fe(lll) redox system. Cu(ll)ions can be supplied by the oxidation-reduction between the plated copper structures to be etched and Fe(lll)ions in the etching process, giving Cu(ll)ions and Fe(ll)ions again.

The reverse reaction occurs in the electrolytic solution. The key is that the same organic additives can be used both in the electrolytic and in the etching solution.

The present invention is more specifically described in the following non-limiting examples.

### Examples

All experiments were carried out in a dipping type electroplating bath using an inert platinised titanium anode.

200 mm wafer quarter pieces patterned with a RDL test mask were used as substrate material to be treated.

The process parameters were set as follows: dipping time for electrolytic copper deposition: 90 min, wafer rotation = none, current density = 3 A/dm². The copper deposit thickness (surface layer thickness) was 2.6 to 2.9 µm. The copper thickness was to satisfy the planarization of surface flatness (no dimples on surface) after the pattern filling of copper plating.

### Example 1 according to the present invention

A base solution comprising 50 g/l copper ions, 100 g/l sulphuric acid, 50 mg/l chloride ions, 2 mg/l of the organic sulfur compound bis-(p-sulfophenyl)-disulfide and 300 mg/l of polyethylenglycol, M = 1.500 - 2.000 was used for copper plating The plating sequence and parameters are shown in Table 1. The solution according to plating step 2. additionally to the base solution as mentioned above contains 6.0 g/l iron ions (added as Fe₂(SO₄)₃*9H₂0).

The copper deposit structures plated contain lines (width Φ greater than 3 µm), bumps (width Φ greater than 3 µm), small vias (diameter Φ smaller than 15 µm) and large vias (diameter Φ greater than 15 µm).

The substrate is first electroplated with copper in a plating bath containing the base solution as described in Table 1, Plating 1. The plating bath does not contain iron ions ("w/o iron"). Thereafter, the substrate is moved to a second plating bath additionally containing iron (Table 1, Plating 2). The substrates and obtained copper deposit structures (line, small via and large via) on the substrate are shown in Figures 2A and 2B as schematic cross sectional images.

After plating is completed, the current is stopped and the copper plated substrate remains in the same bath for etching for 30 minutes as shown in Table 1 ("Etching with iron").

Figures 2A and 2B show cross sectional views (schematic) of the etched structures: lines, small via and large via and its dimensions. The copper layer on the etched sample was very smooth. Also, no undesired over-etching on the corners (called doming) was observed.

Figures 1A and 1B show values for Δt = tₛ / t x 100 as a measure of uniformity of the etched surface. Δt is the ratio of the thickness t of the entire copper deposited in the feature (e.g. blind via, bump or line) and on the substrate and the thickness tₛ, which is the difference between the plated maximum thickness and the minimum thickness of the etched copper layer on the surface of the substrate as shown in Figures 1A and 1B. The smaller the Δt value, the more uniform the surface is.

As becomes apparent from Figures 1A and 1B, for surfaces etched with a method and in a plating bath according to the present invention Δt is smaller than 1% and 1.5%, respectively, which is far superior to results as obtained with methods according to the comparative example, where Δt is smaller than 5% and 8% (see Figures 1A and 1B and for individual values Tables 2 and 3). The values for Δt is the average as obtained from several measurements. The Δt values are obtained from the height measurement value from the surface bottom (ts) after plating to doming top as the below examples and calculated by the percentage of design value of depth (t).

The Δt values corresponding to the Example according to the present invention are shown in the left columns of Tables 2 and 3("Etched by the bath with organic additives"). The comparative Example is shown in the right hand columns of Tables 2 and 3("Etched by the bath with organic additives").

### Example 2 - comparative

The plating step was performed with a substrate and process according to Example 1 resulting in a substrate having structures as shown in Figures 1A and 1B. The such plated substrate was then removed from the plating bath solution. Etching was performed in a solution comprising 35 g/l copper ions, 170 g/l sulphuric acid, 50 mg/l chloride ions, 6.0 g/l iron ions (added as Fe₂(SO₄)₃*9H₂0), 300 mg/l of polyethylenglycol (PEG 3000), but not 2 mg/l of the organic sulfur compound bis-(sodiumsulfopropyl)-disulfide (SPS). Etching time was 30 minutes, no current was applied.

The copper layer on the etched sample was much rougher than the one obtained in Example 1. Undesired over-etching on the corners (called doming) was observed as shown in Figures 1A and 1B.

As becomes apparent from Figures 1A and 1B, far right Blind Micro Via, surfaces etched with a method and in a plating bath without organic additives, the average roughness Δt is only smaller than 5% and 8%, respectively. This indicates a far less uniform surface than obtained with a method according to the present invention. Such rougher surfaces are far less suitable for use in the electronics applications mentioned in this invention.

**Table 1: Plating and etching conditions (according to Method 1 described above)**

| **Process Step** | **Time/ min** | **Temperature /°C** | **Pulse / current** | **Current density /ASD** | **Pulse time / ms** |
|---|---|---|---|---|---|
| Cleaning Water | 1 | 25 | - | - | - |
| Plating 1 w/o iron | 20 | 25 | DC | 0.3 | - |
| Plating 2. with iron | 60 | 25 | forward reverse | 0.5 -1.0 | 80 2 |
| Etching with iron | 30 | 25 | No current | - | - |
| Cleaning Water | 1 | 25 | - | - | - |

**Table 2: Uniformity values for: Small / Large Via (i.e. Small Via n=1; tₛ=0.28µm, t=30 µm, Δt = 0.93%)**

| | **Sample No.** | **Etched by the bath with organic additives** | **Sample No.** | **Etched by the bath without organic additives** |
|---|---|---|---|---|
| Small Via (φ <15µm ) | **1** | 0.28µm / 30µm X 100 = 0.93% | **1** | 1.41µm / 30µm X 100 = 4.70% |
| 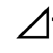 **t** | **2** | 0.21 µm / 30µm X 100 = 0.70% | **2** | 1.39µm / 30µm X 100 = 4.63% |
| | **3** | 0.26µm / 30µm X 100 = 0.86% | **3** | 1.48µm / 30µm X 100 = 4.93% |
| Large Via (φ >15µm ) | **1** | 0.87µm / 60µm X 100 = 1.45% | **1** | 4.61µm / 60µm X 100 = 7.68% |
| 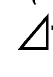 **t** | **2** | 0.71µm 60µm X 100 =1.18% | **2** | 3.32µm / 60µm X 100 = 5.53% |
| | **3** | 0.83µm / 60µm X 100 = 1.38% | **3** | 3.98µm / 60µm X 100 = 6.63% |

**Table 3: Uniformity values for: Bump / Line (i.e. Bump n=1; tₛ=0.46 µm, t = 50 µm, Δt = 0.92%)**

| | **Sample No.** | **Etched by the bath with organic additives** | **Sample No.** | **Etched by the bath without organic additives** |
|---|---|---|---|---|
| **Bump** (Ø **>15µm)** | **1** | 0.46µm / 50µm X 100 = 0.92% | **1** | 2.41 µm / 50µm X 100 = 4.82% |
| 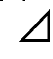 **t** | **2** | 0.35µm / 50µm X 100 = 0.70% | **2** | 2.22µm / 50µm X 100 = 4.44% |
| | **3** | 0.48µm / 50µm X 100 = 0.73% | **3** | 2.39µm / 50µm X 100 = 4.78% |
| Line (φ >3µm) | **1** | 0.19µm / 20µm X 100 = 0.95% | **1** | 0.98µm / 20µm X 100 = 4.90% |
| 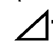 **t** | **2** | 0.17µm / 20µm X 100 = 0.85% | **2** | 0.88µm / 20µm X 100 = 4.40% |
| | **3** | 0.14µm / 20µm X 100 = 0.70% | **3** | 0.93µm / 20µm X 100 = 4.65% |

## Claims

1. Method for etching circuit structures of copper or copper alloys on a substrate, comprising bringing into contact the surface of copper or copper alloys with an etching solution comprising
(i) Cu(ll) ions;
(ii) an Fe(ll)/Fe(lll) redox system;
(iii) at least one organic sulfur brightener additive compound
and wherein no external current source is applied to the work piece.

2. Method according to claim 1 wherein the concentration of Fe(lll) ions ranges between 3 and 10 g/l.

3. Method according to any of the foregoing claims wherein the organic sulfur brightener additive compound is selected from the group consisting of 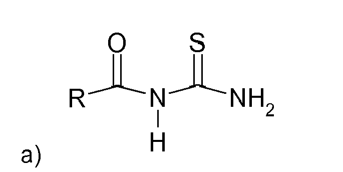 wherein R = H, C₁-C₄ alkyl 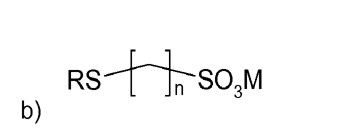 wherein R = H, C₁-C₄ alkyl, n = 1-6 and M = H, metal ion 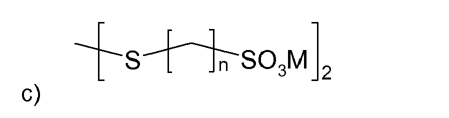 wherein n = 1-6 and M = H, metal ion 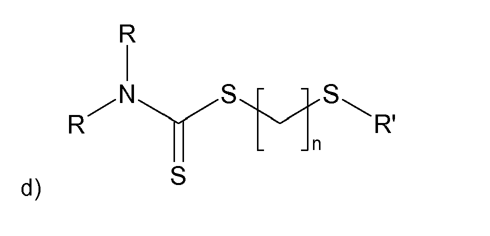 wherein n = 1-6 and R, R' =H, C₁-C₆ alkyl 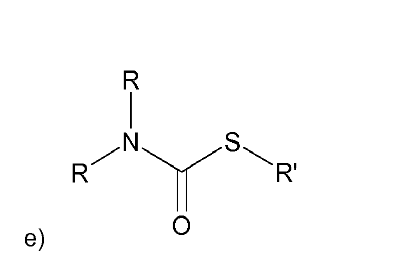 wherein R, R' = H, C₁-C₆ alkyl 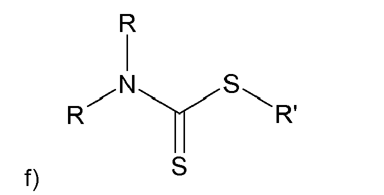 wherein R, R' = H, C₁-C₆ alkyl 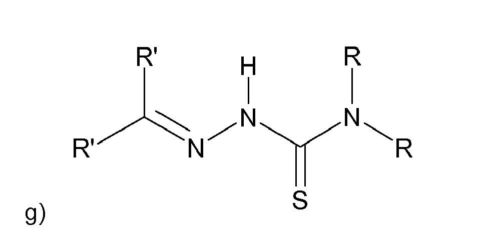 wherein R, R^{'} = H, C₁-C₆ alkyl 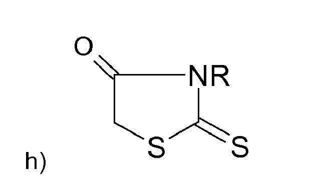 wherein R = H, C₁-C₆ alkyl

4. Method according to any of the foregoing claims wherein R preferably is selected from the group consisting of H, CH₃ and C₂H₅.

5. Method according to any of the foregoing claims wherein R' preferably is selected from the group consisting of H, CH₃ and C₂H₅.

6. Method according to any of the foregoing claims wherein n preferably is 2, 3 or 4.

7. Method according to claims 1 or 2 wherein the at least one organic sulfur brightener additive is selected from the group consisting of 3-(benzthiazolyl-2-thio)-propylsulfonic-acid, 3-mercaptopropan-1-sulfonic-acid, ethylendithiodipropylsulfonic-acid, bis-(p-sulfophenyl)-disulfide, bis-(ω-sulfobutyl)-disulfide, bis-(ω-sulfohydroxypropyl)-disulfide, bis-(ω-sulfopropyl)-disulfide, bis-(ω-sulfopropyl)-sulfide, methyl-(ω-sulfopropyl)-disulfide, methyl-(ω-sulfopropyl)-trisulfide, O-ethyl-dithiocarbonic-acid-S-(ω-sulfopropyl)-ester, thioglycol-acid, thiophosphoric-acid-O-ethyl-bis-(ω-sulfopropyl)-ester, thiophosphoric-acid-tris-(ω-sulfopropyl)-ester and their corresponding salts.

8. Method according to any of the foregoing claims wherein the solution additionally contains a polyether or polyamine.

9. Method according to claim 8 wherein the polyether has the following chemical formula 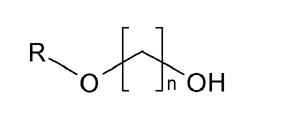 wherein R = H, phenyl, C₁-C₃ alkyl and n = 100 - 3.000.

10. Method according to any of the foregoing claims wherein the solution additionally contains chloride ions in a concentration from 0.01 mg/l to 100 mg/l.

11. Method according to any of the foregoing claims wherein the etching is performed for a time of between 10 - 60 minutes.

12. Method according to any of the foregoing claims wherein the etching is performed at a temperature of between 20°C and 30°C.

13. A method for electrodepositing circuit structures of copper or copper on substrates comprising lines and vias comprising the following steps
i. providing a substrate containing at least one via, wherein the via includes an inner surface having an internal width dimension in the range from 5 µm to 30 µm, a depth from 25 µm to 500 µm and at least one line, wherein the line includes an inner surface having an internal width dimension in the range from 0.3 µm to 100 µm, a depth from 0.1 µm to 100 µm; and
ii. immersing the substrate into an electrolytic copper plating bath with the basic metal layer connected as a cathode, the system further comprising an insoluble dimensionally stable anode and a source of copper metal, wherein the electrolytic bath comprises an acid, a source of copper ions, a source of ferrous and/or ferric ions, and at least one organic sulfur containing brightener additive; and
iii. applying an electrical voltage between the insoluble dimensionally stable anode and the basic metal layer, so that a current flows therebetween for a time sufficient to electrodeposit copper in the structures comprising lines and vias; and
iv. discontinuing the voltage and etch the circuit structures according to a method of one of the foregoing claims 1 - 12.
